**Europäisches Patentamt**

**European Patent Office**

**Office européen des brevets**

(11) Veröffentlichungsnummer: **0 175 942**
**B1**

(12) # EUROPÄISCHE PATENTSCHRIFT

(45) Veröffentlichungstag der Patentschrift:
18.01.89

(51) Int. Cl.⁴: **H05K 7/14**

(21) Anmeldenummer: 85110693.0

(22) Anmeldetag: 26.08.85

(54) Rahmen zur Aufnahme von einschiebbaren elektrischen Baugruppen.

(30) Priorität: 03.09.84 DE 3432367

(43) Veröffentlichungstag der Anmeldung:
02.04.86 Patentblatt 86/14

(45) Bekanntmachung des Hinweises auf die Patenterteilung:
18.01.89 Patentblatt 89/3

(84) Benannte Vertragsstaaten:
AT CH DE FR GB IT LI SE

(56) Entgegenhaltungen:
DE-A- 3 112 595
DE-B- 1 204 292
FR-A- 2 430 164

(73) Patentinhaber: **Siemens Aktiengesellschaft Berlin und München, Wittelsbacherplatz 2, D-8000 München 2(DE)**

(72) Erfinder: **Thom, Günter, Ing.grad., Untertaxetweg 6, D-8035 Gauting(DE)**
Erfinder: **Zell, Karl, Ing.-grad., Moritz-von-Schwind-Weg 80, D-8130 Niederpöcking(DE)**

## Beschreibung

Die Erfindung bezieht sich auf einen Rahmen zur Aufnahme von einschiebbaren elektrischen Baugruppen, die mit Steckerleisten versehen sind, welche auf Kontaktelemente einer Rückwandverdrahtung aufsteckbar sind.

Durch die DE-OS 3 112 595 ist es bekannt, bei einem derartigen Baugruppenrahmen die Rückwandverdrahtung mit einer Verdrahtungsplatte zu versehen, in die die Kontaktelemente eingesetzt sind. Die Verdrahtungsplatte ist in ihrem Randbereich an Tragschienen des Baugruppenrahmens durch Schrauben befestigt. Zusätzlich zu den äußeren Tragschienen ist eine mittlere Tragschiene vorgesehen, die Bestandteil der Rahmenkonstruktion des Baugruppenrahmens ist und sich im zusammengebauten Zustand zwischen den Kontaktelementen der Rückwandverdrahtung erstreckt. Die Verdrahtungsplatte ist an mehreren Stellen mit der mittleren Tragschiene durch Schrauben verbunden. Die mittlere Tragschiene nimmt einen Teil der beim Stecken der Baugruppen entstehenden Kräfte auf und verringert dadurch die sonst entstehende überhöhte Durchbiegung der Verdrahtungsplatte.

Derartige Tragschienen müssen, um die Verdrahtungsplatte anschrauben zu können, eine Mindestbreite aufweisen, die die Belegbarkeit der Rückwand mit Kontaktelementen verringert. Als Bestandteil des Baugruppenrahmens können die Tragschienen nicht beliebig angeordnet werden, so daß dadurch die Freiheit der Belegung des Baugruppenrahmens mit Steckverbindern beeinträchtigt ist.

Der Erfindung liegt die Aufgabe zugrunde, den Baugruppenrahmen so auszubilden, daß die Verdrahtungsplatte hinreichend versteift wird und optimal mit Kontaktelementen und Leiterbahnen belegt werden kann.

Diese Aufgabe wird durch die Erfindung gemäß Anspruch 1 gelöst. Durch die Loslösung des Versteifungskörpers von der Rahmenkonstruktion ist es möglich, diesen in höherer Anzahl an beliebigen Stellen und in beliebiger Koordinatenrichtung an der Verdrahtungsplatte anzuordnen. Es ergibt sich damit die Möglichkeit, die Lage der Versteifungskörper der Belegung der Rückwand mit Steckkontakten und/oder Leiterbahnen anzupassen.

Die Versteifungskörper verstärken die Rückwand in sich. Dabei liegen die Befestigungsstellen zumindest an den Enden und in der Mitte des Versteifungskörpers. Durch die Loslösung von der Rahmenkonstruktion ist es möglich, Versteifungskörper auch auf der den Baugruppen abgewandten Seite der Verdrahtungsplatte anzuordnen. Außerdem können die Verdrahtungskörper bereits vor dem Einbau der Verdrahtungsplatte mit dieser verbunden werden, was den Herstellungsaufwand verringert.

Vorteilhafte Weiterbildungen der Erfindung sind in den Ansprüchen 2 bis 8 gekennzeichnet:

Durch die Weiterbildung nach Anspruch 2 können die Versteifungskörper in gleicher Weise wie die Kontaktelemente an der Verdrahtungsplatte befestigt werden. Beispielsweise ist es möglich, die stiftartigen Vorsprünge gleichzeitig mit den Kontaktelementen in den Bohrungen durch Schwallöten festzulegen. Es ist also dabei nicht mehr nötig, die Befestigung an den einzelnen Verbindungsstellen nacheinander auszuführen.

Durch die Angleichung der Querschnittsabmessungen nach Anspruch 3 sowie die Anordnung der Bohrungen im Rastermaß können die Versteifungskörper in enger Abstufung an der Verdrahtungsplatte verteilt angeordnet werden. Die Herstellung der zugehörigen Bohrungen erfolgt in einem Zuge mit der Herstellung der Bohrungen für die Kontaktelemente, ohne das andere Werkzeuge eingesetzt werden müssen.

Durch die Vielzahl der Vorsprünge nach Anspruch 4 können die Abstützstellen eng benachbart angeordnet werden. Das Einpressen in die Bohrungen der Verdrahtungsplatte läßt sich schnell und einfach durchführen.

Durch die Weiterbildung nach Anspruch 5 kann der Versteifungskörper bei geringem Flächenverbrauch sehr stabil ausgeführt werden. Er kann z.B. als elektrischer Leiter dienen, durch den Leiterbahnen, z.B. der Stromzuführung, miteinander verbunden werden können. Legt man den Versteifungskörper an Erde, so dient er der Schirmung zwischen Gruppen benachbarter Kontaktelemente.

Durch die Weiterbildung nach Anspruch 6 können bei entsprechender Höhe der Versteifungskörper benachbarte Steckerleisten gegeneinander geschirmt werden. Durch seine Schlankheit benötigt der Versteifungskörper nur einen geringen Zwischenraum zwischen den Steckerleisten, so daß diese sehr eng aneinandergereiht werden können. Die Dicke der Versteifungskörper bemißt sich nach den Einpreßmaßen der Vorsprünge. Versieht man den Versteifungskörper mit nockenartigen Ausprägungen, so kann der zur seitlichen Abstützung und Führung der Steckerleisten der einschiebbaren Baugruppen dienen, so daß man dann keinen zusätzlichen Führungskörper benötigt, der an die Verdrahtungsplatte angesetzt werden müßte.

Durch die Weiterbildung nach Anspruch 7 ist es möglich, die Steckerleisten auch stirnseitig abzustützen und zu führen. Durch die Weiterbildung nach Anspruch 8 ist es möglich, eine Leiterbahn mit dem Versteifungskörper doppelt zu kontaktieren, was einen großflächigen und besonders sicheren Übergang ergibt. Es ist üblich, Rückwände zusätzlich zu den Verdrahtungsplatten mit Schaltdrähten zu versehen, die zwischen den Kontaktelementen verlegt sind. Auf dieser Seite ist es angezeigt, den Versteifungskörper in größerem Abstand über der Verdrahtungsplatte zu führen. Das bedeutet, daß die Vorsprünge entsprechend länger sein müssen. Aus Stabilitätsgründen ist es vorteilhaft, die beiden einander benachbarten Vorsprünge bis unmittelbar über der Verdrahtungsplatte einstückig auszubilden und erst in ihrem Endbereich durch eine schlitzartige Ausnehmung zu trennen.

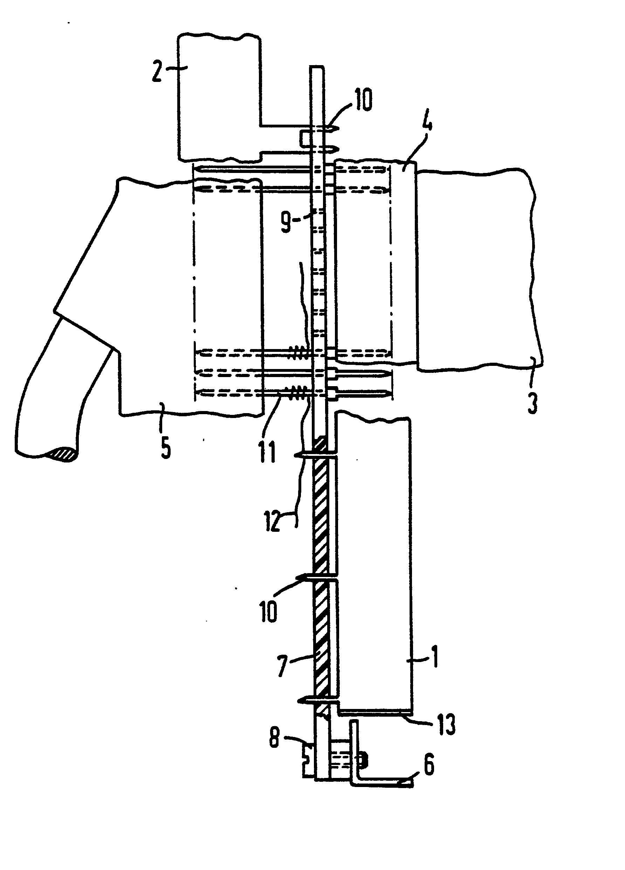

Im folgenden wird die Erfindung anhand eines in der Zeichnung dargestellten Ausführungsbeispieles näher erläutert. Die dargestellte Figur zeigt schematisiert eine Seitenansicht eines Teiles eines Baugruppenrahmens mit einer Rückwandverdrahtung, Versteifungskörpern 1, 2, einer einschiebbaren elektrischen Baugruppe 3, 4, einem Kabelstecker 5, einem Rahmenteil 6 und einer Verdrahtungsplatte 7.

Das Rahmenteil 6 ist Teil der Rahmenkonstruktion des Baugruppengehäuses. Die Verdrahtungsplatte 7 ist durch Schrauben 8 an dem Rahmenteil 6 befestigt. Die Verdrahtungsplatte 7 ist mit Bohrungen 9 versehen, in die wahlweise stiftartige Vorsprünge 10 der Versteifungskörper 1, 2 und Kontaktelemente 11 für den Steckanschluß der Baugruppen 3, 4 und der Kabelstecker 5 eingepreßt sind.

Die Baugruppen 3, 4 weisen Leiterplatten 3 und Steckerleisten 4 auf, die im eingeschobenen Zustand mit den Kontaktelementen 11 kontaktiert sind. Die Kabelstecker 5 sind auf der den Baugruppen 3, 4 abgewandten Seite der Verdrahtungsplatte 7 angeordnet und mit den anderen Enden der Kontaktelemente 11 kontaktiert. Die Verdrahtungsplatte 7 ist mit nicht dargestellten Leiterbahnen versehen, die die Kontaktelemente 11 miteinander elektrisch verbinden. Zusätzlich zu den Leiterbahnen der Verdrahtungsplatte 7 sind Schaltdrähte 12 vorgesehen, die an die Kontaktelemente 11 auf der den Baugruppen 3, 4 abgewandten Seite angeschlossen sind. Die Versteifungskörper 1 mit den Vorsprüngen 10 sind als flache Blechteile ausgebildet, die sich im wesentlichen in Längsrichtung der Steckerleisten 4 erstrecken. Sie sind losgelöst von den Rahmenteilen 6 lediglich mit der Verdrahtungsplatte 7 verbunden und stehen senkrecht zu dieser ab. Ihre Länge erreicht annähernd die Breite der Verdrahtungsplatte 7 in der Erstreckungsrichtung.

Die Versteifungsbleche 1 können z.B. zwischen zwei eng benachbarten Steckerleisten 4 angeordnet sein. Sie sind über die Verdrahtungsplatte 7 mittels der Vorsprünge 10 mit Erdpotential verbunden. Ihre Höhe entspricht annähernd der der Steckerleisten. Derartig angeordnete Versteifungskörper 1 dienen dann der Schirmung der beiden Steckerleisten 4 gegeneinander. Durch seitliche Ausprägungen an den Versteifungskörpern 1 ist es möglich, daß sich die Steckerleisten 4 an diesen Stellen abstützen und seitlich geführt werden. Die Versteifungskörper 1 sind an ihren Enden mit rechtwinkelig abgebogenen Lappen 13 versehen, der der stirnseitigen Führung und Abstützung der Steckerleisten 4 dienen.

Auf der Seite der Schaltdrähte 12 ist ein weiterer Versteifungskörper 2 in größerem Abstand zu der Verdrahtungsplatte 7 angeordnet. Die Vorsprünge 10 sind entsprechend verlängert. Jeweils zwei benachbarte Vorsprünge 10 sind in zwei unmittelbar benachbarte Bohrungen 9 der Verdrahtungsplatte 7 eingepreßt. Sie sind bis unmittelbar über der Verdrahtungsplatte durch eine Blechbrücke einstückig miteinander verbunden. Auch diese Versteifungskörper können an Erdpotential gelegt sein und der Schirmung zwischen benachbarten Kabelsteckern 5 bzw. rückseitig aufgesteckten Baugruppen dienen.

## Patentansprüche

1. Rahmen zur Aufnahme von einschiebbaren elektrischen Baugruppen, die mit Steckerleisten versehen sind, welche auf Kontaktelemente einer Rückwandverdrahtung aufsteckbar sind, die eine Verdrahtungsplatte aufweist, in die die Kontaktelemente eingesetzt sind, wobei zwischen den Kontaktelementen zumindest ein Versteifungskörper für die Verdrahtungsplatte angeordnet ist, dadurch gekennzeichnet, daß der Versteifungskörper (1, 2) ohne unmittelbare Verbindung mit dem Baugruppenrahmen (6) zumindest an drei Stellen fest mit der Verdrahtungsplatte (7) verbunden ist.

2. Rahmen nach Anspruch 1, dadurch gekennzeichnet, daß der Versteifungskörper (1, 2) mit stiftartigen Vorsprüngen (10) versehen ist, die in gleicher Weise wie die Kontaktelemente (11) in Bohrungen (9) der Verdrahtungsplatte (7) eingesetzt und gehalten sind.

3. Rahmen nach Anspruch 2, dadurch gekennzeichnet, daß die Vorsprünge (10) die gleichen Querschnittsabmessungen aufweisen wie die Kontaktelemente (11) im Einsetzbereich und daß die zugehörigen Bohrungen (9) im Rastermaß der Bohrungen für die Kontaktelemente (11) angeordnet sind und die gleichen Abmessungen wie diese aufweisen.

4. Rahmen nach Anspruch 3, dadurch gekennzeichnet, daß eine Vielzahl von über die gesamte Länge verteilten Vorsprüngen (10) vorgesehen und in die Bohrungen (9) eingepreßt sind.

5. Rahmen nach einem der vorhergehenden Ansprüche, dadurch gekennzeichnet, daß der Versteifungskörper (1, 2) aus Metallblech gestanzt ist, senkrecht zur Verdrahtungsplatte (7) steht und diese nur mit den Vorsprüngen berührt.

6. Rahmen nach Anspruch 5, dadurch gekennzeichnet, daß sich die Versteifungskörper (1, 2) im wesentlichen entlang der Steckerleisten (4) bzw. von Kabelsteckern (5) erstrecken.

7. Rahmen nach Anspruch 6, dadurch gekennzeichnet, daß die Enden der Versteifungskörper (1, 2) rechtwinkelig abgebogen sind und die Stirnseiten der Steckerleisten (4) bzw. der Kabelstecker (5) zumindest teilweise umgreifen.

8. Rahmen nach einem der vorhergehenden Ansprüche, dadurch gekennzeichnet, daß zwei Vorsprünge (10) im Teilungsabstand der Bohrungen (9) unmittelbar nebeneinander angeordnet sind.

## Claims

1. Frame for receiving slidable electrical assemlies equipped with plug connector strips which can be plugged onto contact elements of a wiring backplane, which has a wiring plate into which the contact elements are inserted, at least one stiffening member for the wiring plate being arranged between the contact elements, characterized in that the stiffening member (1, 2) is connected firmly at at least three points to the wiring plate (7) without direct connection to the assembly frame (6).

2. Frame according to claim 1, characterized in that the stiffening member (1, 2) is provided with pinlike projections (10) which are inserted and held in bores (9) of the wiring plate (7) in the same manner as the contact elements (11).

3. Frame according to claim 2, characterized in that the projections (10) have the same cross-sectional dimensions as the contact elements (11) in the region of insertion and in that the associated bores (9) are arranged in the raster spacing of the bores for the contact elements (11) and have the same dimensions as the latter.

4. Frame according to claim 3, characterized in that a plurality of projections (10) distributed over the entire length are provided and are pressed into the bores (9).

5. Frame according to one of the preceding claims, characterized in that the stiffening member (1, 2) is punched from sheet metal, stands perpendicular to the wiring plate (7) and touches the latter only with the projections.

6. Frame according to claim 5, characterized in that the stiffening members (1, 2) essentially extend along the plug connector strips (4) or from cable connectors (5).

7. Frame according to claim 6, characterized in that the ends of the stiffening members (1, 2) are bent at right angles and surround at least partially the end face is of the plug connector strips (4) or the cable connectors (5).

8. Frame according to one of the preceding claims, characterized in that two projections (10) are arranged directly next to one another in the pitch spacing of the bores (9).

**Revendications**

1. Châssis servant à recevoir des modules électriques enfichables qui sont équipés de barrettes de connexion pouvant être enfichées sur des éléments de contact d'un câblage situé sur la face arrière, que comporte une plaque de câblage, dans laquelle les éléments de contact sont insérés, au moins un corps de renforcement pour la plaque de câblage étant disposé entre les éléments de contact, caractérisé par le fait que le corps de renforcement (1, 2) est relié rigidement, au moins en trois points, à la plaque de câblage (7), sans aucune liaison directe avec le châssis servant à recevoir les modules.

2. Châssis suivant la revendication 1, caractérisé par le fait que le corps de renforcement (1, 2) est équipé d'éléments saillants en forme de pointes (10), qui sont insérés et maintenus de la mème manière que les éléments de contact (11) dans des perçages (9) de la plaque de câblage (7).

3. Châssis suivant la revendication 2, caractérisé par le fait que les éléments saillants (10) possèdent les mêmes dimensions en coupe transversale que les éléments de contact (11) dans la zone d'insertion et que les perçages associés (9) sont disposés avec le même pas de résseau que les perçages prévus pour les éléments de contact (11) et possèdent les mêmes dimensions que ces derniers.

4. Châssis suivant la revendication 3, caractérisé par le fait qu'il est prévu une multiplicité d'éléments saillants (10) répartis sur toute la longueur et insérés à force dans les perçages (9).

5. Châssis suivant l'une des revendications précédentes, caractérisé par le fait que le corps de renforcement (1, 2) est formé par découpage dans une tôle métallique, est perpendiculaire à la plaque de câblage (7) et est en contact avec cette dernière uniquement au moyen des éléments saillants.

6. Châssis suivant la revendication 5, caractérisé par le fait que les corps de renforcement (1, 2) s'étendent sensiblement le long des barrettes de connexion (4) ou de connecteurs de câbles (5).

7. Châssis suivant la revendication 6, caractérisé par le fait que les extrémités des corps de renforcement (1, 2) sont coudés à angle droit et enserrent au moins partiellement les faces frontales des barrettes de connexion (4) ou des connecteurs de câbles (5).

8. Châssis suivant l'une des revendications précédentes, caractérisé par le fait que deux éléments saillants (10) sont disposés directement côte-à-côte à une distance égale au pas de répartition des perçages (9).